# EUROPEAN PATENT APPLICATION

(11) **EP 4 660 677 A1**
(43) Date of publication of application: **10.12.2025**
(21) Application number: 24769849.1
(22) Date of filing: 07.03.2024
(51) Int. Cl.: G02B 6/42, H01S 5/022

(54) **TUBE HOUSING PACKAGING STRUCTURE, PACKAGING ASSEMBLY AND ELECTRONIC DEVICE**

(30) Priority: 10.03.2023 CN 202310261080
(71) Applicant: Huawei Technologies Co., Ltd., Shenzhen, Guangdong 518129 (CN)
(72) Inventor: QUAN, Mingran, Shenzhen, Guangdong 518129 (CN); SONG, Xiaolu, Shenzhen, Guangdong 518129 (CN); LI, Yang, Shenzhen, Guangdong 518129 (CN); LV, Haifeng, Shenzhen, Guangdong 518129 (CN)
(74) Representative: Grünecker Patent- und Rechtsanwälte PartG mbB
(86) International application number: PCT/CN2024/080596
(87) International publication number: WO 2024/188156

(57) **Abstract**

A housing packaging structure (200), a packaging assembly (12), and an electronic device are provided, and relate to the field of device packaging, to improve reliability of a device. A specific solution is as follows: The housing packaging structure (200) includes a packaging housing (210), a thermally conductive portion (220), and an electrical connector (230). The packaging housing (210) is connected to the thermally conductive portion (220) to form a sealed cavity (201), where the sealed cavity (201) is configured to accommodate a signal transmission device (20), a thermal conductivity coefficient of the thermally conductive portion (220) is greater than a thermal conductivity coefficient of the packaging housing (210), and the electrical connector (230) runs through the packaging housing (210). A material with poor thermal conductive performance may be selected for the packaging housing (210), thereby increasing selectivity of a material for the packaging housing (210). A material that is not easy to deform at a high temperature or a material whose coefficient of thermal expansion adapts to that of the signal transmission device (20) may be selected for the packaging housing (210), to offer the housing packaging structure (200) advantages such as good thermal conductive performance and good mechanical performance, thereby ensuring reliability of the signal transmission device (20); or glass with low costs may be selected for the packaging housing (210), thereby reducing costs of the housing packaging structure (200).

## Description

This application claims priority to Chinese Patent Application No. 202310261080.5, filed with the China National Intellectual Property Administration on March 10, 2023 and entitled "HOUSING PACKAGING STRUCTURE, PACKAGING ASSEMBLY, AND ELECTRONIC DEVICE", which is incorporated herein by reference in its entirety.

### TECHNICAL FIELD

Embodiments of this application relate to the field of device packaging, and in particular, to a housing packaging structure, a packaging assembly, and an electronic device.

### BACKGROUND

Airtight packaging refers to packaging that can prevent intrusion and corrosion of a pollutant (for example, a liquid, a gas, or a solid). Therefore, the airtight packaging has a high requirement for airtightness performance of an airtight packaging structure. Usually, the airtight packaging structure is not convenient for replacement and maintenance. After a device (for example, a chip) is packaged in the airtight packaging structure, it is difficult to make adjustment inside the airtight packaging structure of the device. Therefore, performance of the airtight packaging structure is one of main factors that affect reliability of the device.

### SUMMARY

Embodiments of this application provide a housing packaging structure, a packaging assembly, and an electronic device, to resolve a problem of reduced device reliability due to a packaging structure.

To achieve the foregoing objective, this application uses the following technical solutions.

According to a first aspect of this application, a housing packaging structure is provided. The housing packaging structure is configured to package a signal transmission device, and the housing packaging structure includes a package housing, a thermally conductive portion, and an electrical connector. The packaging housing is connected to the thermally conductive portion to form a sealed cavity, the sealed cavity is configured to accommodate the signal transmission device, and a thermal conductivity coefficient of the thermally conductive portion is greater than a thermal conductivity coefficient of the packaging housing. The electrical connector runs through the packaging housing, one end of the electrical connector is configured to be electrically connected to the signal transmission device, and the other end is located outside the sealed cavity. In this way, because the thermal conductivity coefficient of the thermally conductive portion is greater than the thermal conductivity coefficient of the packaging housing, thermal conductive performance of the thermally conductive portion is better than thermal conductive performance of the packaging housing. Heat in the sealed cavity may be preferentially transferred to the outside of the sealed cavity by using the thermally conductive portion, to avoid impact on performance of the signal transmission device due to poor thermal conductive performance of the housing packaging structure. Because the electrical connector is connected to the packaging housing, the heat in the sealed cavity has small impact on the electrical connector, thereby ensuring good performance of connection between the signal transmission device and the electrical connector, and improving reliability of the signal transmission device. In addition, a material with poor thermal conductive performance may be selected for the packaging housing, so as to increase selectivity of a material for the packaging housing. For example, glass with low costs is selected. Alternatively, a material that is not easy to deform at a high temperature may be selected for the packaging housing, so as to avoid damage to performance of connection between the electrical connector and the signal transmission device caused by deformation of the housing packaging structure in a high temperature environment. In addition, the packaging housing that is not easy to deform can avoid reduction of air tightness of the sealed cavity caused by deformation, and can improve reliability of the signal transmission device.

With reference to the first aspect, in some implementations, the signal transmission device has an optical interface, the housing packaging structure further includes a transparent portion, the transparent portion is connected to the packaging housing, and a projection of the optical interface on a surface of the packaging housing is located in an area of the transparent portion. In this way, the transparent portion may allow an optical signal to pass through the sealed cavity, and the housing packaging structure may package the signal transmission device having an optical signal input function or an optical signal output function, thereby improving reliability of the signal transmission device.

With reference to the first aspect, in some implementations, the housing packaging structure is further configured to be connected to an optical element, the housing packaging structure further includes an adapter, the adapter is configured to be connected to the optical element, the adapter is connected to the packaging housing, and a projection of the adapter on a surface of the packaging housing is located in an area of the transparent portion. In this way, the adapter connected to the optical element may be prepared on the packaging housing. When the housing packaging structure is connected to the optical element, assembly time of the adapter may be reduced, and an assembly and adjustment process of the transparent portion and the adapter may be omitted, thereby reducing assembly and adjustment costs.

With reference to the first aspect, in some implementations, a material of the adapter is glass. In this way, a coefficient of thermal expansion of the adapter adapts to that of the transparent portion, a deformation amount of the adapter is close to that of the transparent portion at a high temperature, performance of connection between the adapter and the transparent portion is good, and the housing packaging structure guarantees propagation of an optical signal.

With reference to the first aspect, in some implementations, the adapter and the packaging housing are integrally formed, or the adapter is connected to the packaging housing by using a connecting piece. In this way, the adapter and the packaging housing may be connected in a plurality of connection manners, and a connection manner may be selected according to performance of a material.

With reference to the first aspect, in some implementations, the housing packaging structure is further configured to be connected to an optical element, the housing packaging structure further includes a light leading-out assembly, the light leading-out assembly includes a tube, an optical fiber, and a fastener, the optical fiber is configured to be connected to the optical element, the fastener is sleeved on the optical fiber, an accommodating channel is disposed in the tube, the fastener is located in the accommodating channel and is connected to the tube, and a projection of the optical fiber on a surface of the packaging housing is located in an area of the transparent portion. In this way, after the optical element is connected to the optical fiber, an optical signal in the housing packaging structure may be propagated to the optical element by using the light leading-out assembly, thereby simplifying an assembly process of the optical element and the housing packaging structure.

With reference to the first aspect, in some implementations, the housing packaging structure is further configured to be connected to an optical element, and the housing packaging structure further includes an optical fiber element, where one end of the optical fiber element is connected to the transparent portion, and the other end is configured to be connected to the optical element. In this way, after the optical element is connected to the optical fiber element, an optical signal in the housing packaging structure may be propagated to the optical element by using the optical fiber element, thereby simplifying an assembly process of the optical element and the housing packaging structure.

With reference to the first aspect, in some implementations, one end of the optical fiber element is located in the sealed cavity, and the other end is located outside the sealed cavity. In this way, the optical fiber element located in the sealed cavity may be well coupled to the signal transmission device, so as to achieve an objective of optical signal propagation.

With reference to the first aspect, in some implementations, materials of the tube and the fastener are both glass. In this way, coefficients of thermal expansion of the tube, the fastener, and the transparent portion adapt to each other, deformation amounts of the tube, the fastener, and the transparent portion are close at a high temperature, performance of connection between the light leading-out assembly and the transparent portion is good, and the housing packaging structure guarantees propagation of an optical signal.

With reference to the first aspect, in some implementations, the housing packaging structure further includes a lens assembly, the lens assembly is located between the transparent portion and the fastener, and the lens assembly is connected to the tube. In this way, the lens assembly may shape an optical signal that passes through the transparent portion, so as to be applicable to more optical path designs.

With reference to the first aspect, in some implementations, the transparent portion is a curved mirror. In this way, the curved mirror may shape light.

With reference to the first aspect, in some implementations, the packaging housing is provided with a window that runs through the packaging housing, the transparent portion covers the window, and the transparent portion is connected to the packaging housing by using a connecting layer. In this way, the transparent portion and the packaging housing may be separately manufactured and then assembled, and the transparent portion and the packaging housing may be made of different materials.

With reference to the first aspect, in some implementations, the transparent portion and the packaging housing are integrally formed. In this way, a preparation process of the transparent portion and the packaging housing may be simplified, mechanical strength of a joint between the transparent portion and the packaging housing is high, and air tightness is good, thereby improving mechanical performance of the housing packaging structure, and improving reliability of the signal transmission device.

With reference to the first aspect, in some implementations, the packaging housing includes a substrate and a cover, the cover is located on one side of the substrate and is connected to the substrate, the electrical connector runs through the substrate, the thermally conductive portion is connected to the substrate, and the thermal conductivity coefficient of the thermally conductive portion is greater than a thermal conductivity coefficient of the substrate. In this way, the signal transmission device may be mechanically connected to the substrate, and the signal transmission device is electrically connected to the electrical connector. Both heat of the signal transmission device and heat of the substrate may be transferred to the outside of the sealed cavity by using the thermally conductive portion. In addition, the electrical connector and the thermally conductive portion are independently disposed. Therefore, even if the thermally conductive portion deforms, impact of the deformation on the signal transmission device is small. A material that is not easy to deform may be selected for the substrate, to reduce poor contact between the signal transmission device and the electrical connector caused by warping of the substrate, thereby improving reliability of the signal transmission device.

With reference to the first aspect, in some implementations, the substrate is provided with a thermally conductive hole that runs through the substrate, and the thermally conductive portion is located in the thermally conductive hole. In this way, the substrate and the thermally conductive portion may be separately prepared and then connected.

With reference to the first aspect, in some implementations, the housing packaging structure further includes a first wiring layer, the first wiring layer is connected to a surface of the substrate that faces or is away from the sealed cavity, and the first wiring layer is electrically connected to the electrical connector. In this way, the first wiring layer may increase space for circuit design of the housing packaging structure, and may enrich circuit design solutions of the housing packaging structure, to meet different requirements of the signal transmission device.

With reference to the first aspect, in some implementations, the housing packaging structure further includes a second wiring layer, the substrate includes a plurality of support layers disposed in a stacked manner, one second wiring layer is disposed between two adjacent support layers, the electrical connector runs through each support layer, and the second wiring layer is electrically connected to the electrical connector. In this way, the second wiring layer may enrich circuit design solutions of the housing packaging structure, to meet different requirements of the signal transmission device.

With reference to the first aspect, in some implementations, a material of the cover includes glass. In this way, the glass may avoid immersion of a pollutant such as a gas, and the glass has high strength, so that mechanical performance of the housing packaging structure can be improved.

With reference to the first aspect, in some implementations, a material of the substrate includes at least one of AlN, SiC, AlSiC, glass, Kovar alloy, and Invar alloy. In this way, the foregoing materials all adapt to a coefficient of thermal expansion of silicon. In an embodiment in which the signal transmission device is a silicon-based chip or a ceramic, a coefficient of thermal expansion of the substrate adapts to that of the signal transmission device, and a deformation amount of the substrate is close to that of the signal transmission device. After a temperature of the packaging assembly changes, the substrate is in good contact with the signal transmission device, and mechanical reliability is good, thereby improving reliability of the signal transmission device.

With reference to the first aspect, in some implementations, the cover includes a top plate and an enclosure plate that are connected to each other, the top plate and the substrate are disposed opposite to each other, and the substrate is connected to the enclosure plate. In this way, the cover may be of a split structure, and is connected when the signal transmission device is packaged, so that more packaging processes can be applied.

With reference to the first aspect, in some implementations, a material of the thermally conductive portion includes a metal material. In this way, the metal material has good thermal conductive performance, which can provide good protection for heat dissipation performance of the housing packaging structure, and prevent performance of the signal transmission device from being affected by an excessively high temperature.

With reference to the first aspect, in some implementations, the metal material includes at least one of copper, tungsten, and copper-tungsten alloy. The foregoing material has good thermal conductive performance and air tightness, has a large thermal conductivity coefficient, and has a good thermal conductivity effect.

With reference to the first aspect, in some implementations, the electrical connector is formed by electroplating, chemical plating, sputtering, or electrically conductive slurry curing. In this way, the electrical connector is prepared in many methods, which may be selected according to an actual requirement.

According to a second aspect, a packaging assembly is provided. The packaging assembly includes a signal transmission device and the housing packaging structure provided in the first aspect, the signal transmission device is located in the sealed cavity, and the signal transmission device is electrically connected to the electrical connector. In this way, the foregoing housing packaging structure has good performance, which can improve reliability of the signal transmission device.

With reference to the second aspect, in some implementations, the signal transmission device includes at least one of a light source, a receiver, a modulator, a chip, and a micro-electro-mechanical system device. In this way, good performance of the packaging assembly provides a good environment for the foregoing signal transmission device.

According to a third aspect, an electronic device is provided. The electronic device includes a body and the packaging assembly provided in the second aspect, the packaging housing is connected to the body, and one end of the electrical connector that is located outside the sealed cavity is electrically connected to the body. In this way, good performance of the package assembly can improve reliability of the signal transmission device.

### BRIEF DESCRIPTION OF DRAWINGS

FIG. 1a is a diagram of a structure of an optical fiber transceiver according to an embodiment of this application;
FIG. 1b is a diagram of a structure of a packaging assembly according to an embodiment of this application;
FIG. 1c is a diagram of another structure of a packaging assembly according to an embodiment of this application;
FIG. 2 is a diagram of a structure of a housing packaging structure in a related technology;
FIG. 3 is a diagram of a structure of a housing packaging structure and a signal transmission device according to an embodiment of this application;
FIG. 4 is a diagram of another structure of a housing packaging structure and a signal transmission device according to an embodiment of this application;
FIG. 5 is a diagram of still another structure of a housing packaging structure and a signal transmission device according to an embodiment of this application;
FIG. 6a is a diagram of a structure of a substrate and an electrical connector according to an embodiment of this application;
FIG. 6b is a diagram of another structure of a substrate, an electrical connector, and a signal transmission device according to an embodiment of this application;
FIG. 6c is a diagram of still another structure of a substrate, an electrical connector, and a signal transmission device according to an embodiment of this application;
FIG. 6d is a diagram of yet another structure of a substrate, an electrical connector, and a signal transmission device according to an embodiment of this application;
FIG. 7a is a diagram of a structure of a transparent portion and an enclosure plate according to an embodiment of this application;
FIG. 7b is a diagram of another structure of a transparent portion and an enclosure plate according to an embodiment of this application;
FIG. 8a is a diagram of a structure of a housing packaging structure including an adapter according to an embodiment of this application;
FIG. 8b is a diagram of another structure of a housing packaging structure including an adapter according to an embodiment of this application;
FIG. 9a is a diagram of a connection structure between a housing packaging structure shown in FIG. 8b and an optical element;
FIG. 9b is a diagram of a connection structure between a housing packaging structure shown in FIG. 8b and an optical element;
FIG. 9c is a diagram of a connection structure between a housing packaging structure and an optical element according to an embodiment of this application;
FIG. 9d is a diagram of another connection structure between a housing packaging structure and an optical element according to an embodiment of this application;
FIG. 10a is a flowchart of packaging a signal transmission device by using a housing packaging structure according to an embodiment of this application;
FIG. 10b is a diagram of a structure obtained after S1 in FIG. 10a is performed; and
FIG. 10c is a diagram of a structure obtained after S2 in FIG. 10a is performed.

Reference numerals: 10-optical fiber transceiver; 11-power supply; 12-packaging assembly; 13-collimation lens; 12-packaging assembly; 101-input end; 102-output end; 20-signal transmission device; 200-housing packaging structure; 01-housing packaging structure; 02-housing; 03-bottom plate; 04-chip; 05-high-temperature co-fired ceramic piece; 07-optical window; 06-accommodating cavity; 201-sealed cavity; 202-first wiring layer; 203-second wiring layer; 204-support layer; 210-packaging housing; 211-substrate; 212-cover; 213-top plate; 214-enclosure plate; 220-thermally conductive portion; 230-electrical connector; 240-transparent portion; 250-adapter; 251-accommodating channel; 260-light leading-out assembly; 261-tube; 262-fastener; 263-lens assembly; 206-ferrule; 207-optical element; and 205-optical fiber.

### DESCRIPTION OF EMBODIMENTS

To make the objectives, technical solutions, and advantages of this application clearer, the following further describes this application in detail with reference to the accompanying drawings.

Terms such as "first" and "second" in the following descriptions are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in this application, position terms such as "upper", and "lower" are defined relative to an illustrative position of a component in the accompanying drawings. It should be understood that these direction terms are relative concepts and are used for relative description and clarification, and may vary accordingly depending on a position change in which components are placed in the accompanying drawings.

An embodiment of this application provides an electronic device. A purpose of the electronic device is not limited in this embodiment of this application, and may be set based on a type of the electronic device. For example, the electronic device may be, for example, a device for conversion between an optical signal and an electrical signal, and may be used as a laser emission radar module, an optical fiber transceiver, or an optical module; or the electronic device may be, for example, an electrical signal transmission device, and may be used as a power management device, a power conversion device, or a motor drive device. The following uses an example in which the electronic device is an optical fiber transceiver for description.

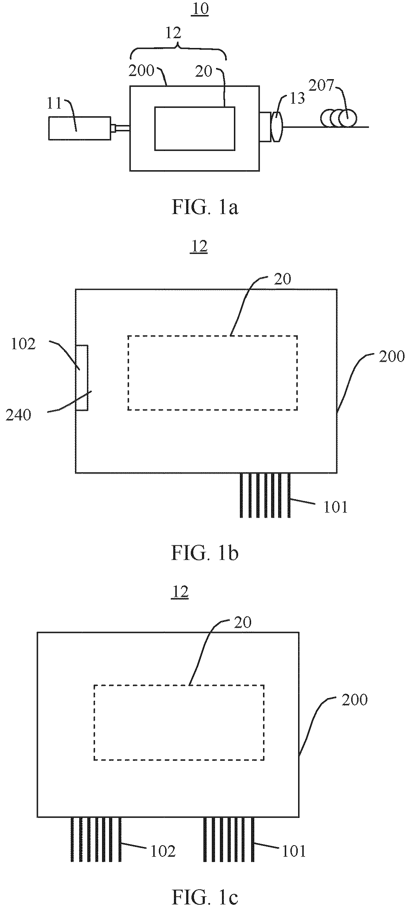

FIG. 1a is a diagram of a structure of an optical fiber transceiver 10 according to an embodiment of this application. Refer to FIG. 1a. The optical fiber transceiver 10 includes a body and a packaging assembly 12, and the packaging assembly 12 is connected to the body. The body includes a power supply 11, a collimation lens 13, and an optical element 207. The packaging assembly 12 includes a housing packaging structure 200 and a signal transmission device 20. The power supply 11 is electrically connected to the signal transmission device 20, and light emitted by the signal transmission device 20 may pass through the collimation lens 13 and is transferred to the optical element 207.

For example, the signal transmission device 20 is a light emitting chip, and the light emitting chip is electrically connected to the power supply 11. The power supply 11 provides an electrical signal for the signal transmission device 20, and the light emitting chip converts the electrical signal into an optical signal and outputs the optical signal from the housing packaging structure 200. The optical element 207 may be a structure such as an optical fiber or an optical cable.

FIG. 1b is a diagram of a structure of the packaging assembly 12 according to an embodiment of this application. Refer to FIG. 1b. The packaging assembly 12 includes a housing packaging structure 200 and a signal transmission device 20, and the signal transmission device 20 is located in the housing packaging structure 200.

A packaging process of the packaging assembly 12 is not limited in this embodiment of this application. For example, the packaging assembly 12 is airtight packaging. The airtight packaging is usually used to protect the signal transmission device 20, and prevent the signal transmission device 20 from being corroded by a pollutant (for example, a gas, a liquid, or a solid), so that the signal transmission device 20 operates reliably.

In FIG. 1b, the packaging assembly 12 includes an input end 101 and an output end 102. A signal connection is present between the input end 101 and the signal transmission device 20, and a signal connection is present between the output end 102 and the signal transmission device 20. Good performance of the housing packaging structure 200 directly affects reliability of the signal transmission device 20. A dashed line in FIG. 1b indicates a location of the signal transmission device 20, and does not mean that the signal transmission device 20 is exposed on an outer surface of the packaging assembly 12.

The foregoing signal connection is not limited in this embodiment of this application. For example, the signal connection may be an optical communication connection or an electrical connection.

A structure of the signal transmission device 20 is not limited in this embodiment of this application. For example, the signal transmission device 20 is, for example, a light source, a receiver, a modulator, a chip, and a micro-electro-mechanical system (micro-electro-mechanical system (micro-electro-mechanical system, MEMS) device).

A structure of the packaging assembly 12 is set according to a type of the signal transmission device 20. In an embodiment in which the signal transmission device 20 is configured to transmit an optical signal, the packaging assembly 12 is provided with a window for light to pass through. In an embodiment in which the signal transmission device is not configured to transmit an optical signal, the packaging assembly 12 may not be provided with a window for light to pass through.

In the example in FIG. 1b, the signal transmission device 20 is a structure having optical signal obtaining performance or optical signal transmitting performance. For example, the signal transmission device 20 may be a structure such as an optical control chip (liquid crystal on silicon), a receiver, or a light source. The input end 101 is an electrical interface, one end of the input end 101 is electrically connected to the signal transmission device 20, and the other end is electrically connected to the power supply 11. The input end 101 is an optical interface, an optical communication connection is present between one end of the output end 102 and the signal transmission device 20, and an optical communication connection is present between the other end and the optical element 207. On the contrary, the input end 101 is an optical interface, and the output end 102 is an electrical interface.

FIG. 1c is a diagram of another structure of the packaging assembly 12 according to an embodiment of this application. A difference between FIG. 1c and FIG. 1b lies in that in FIG. 1c, both the input end 101 and the output end 102 are electrical interfaces. Both the input end 101 and the output end 102 are electrically connected to the signal transmission device 20.

In the example in FIG. 1c, the signal transmission device 20 may not have a structure of optical signal obtaining performance or optical signal transmitting performance. For example, the signal transmission device 20 may be a chip that converts an electrical signal into an electrical signal. In FIG. 1c, the input end 101 is an electrical interface, one end of the input end 101 is electrically connected to the signal transmission device 20, and the other end is electrically connected to a structure such as a power supply. The output end 102 is an electrical interface, one end of the output end 102 is electrically connected to the signal transmission device 20, and the other end is electrically connected to an electrical signal receiving device.

In FIG. 1c, both the input end 101 and the output end 102 are located on one side of the packaging assembly 12. It may be understood that relative locations of the input end 101 and the output end 102 are not limited in this embodiment of this application. For example, the input end 101 and the output end 102 may be opposite, or the input end 101 and the output end 102 may be separately located on two adjacent sides of the packaging assembly 12.

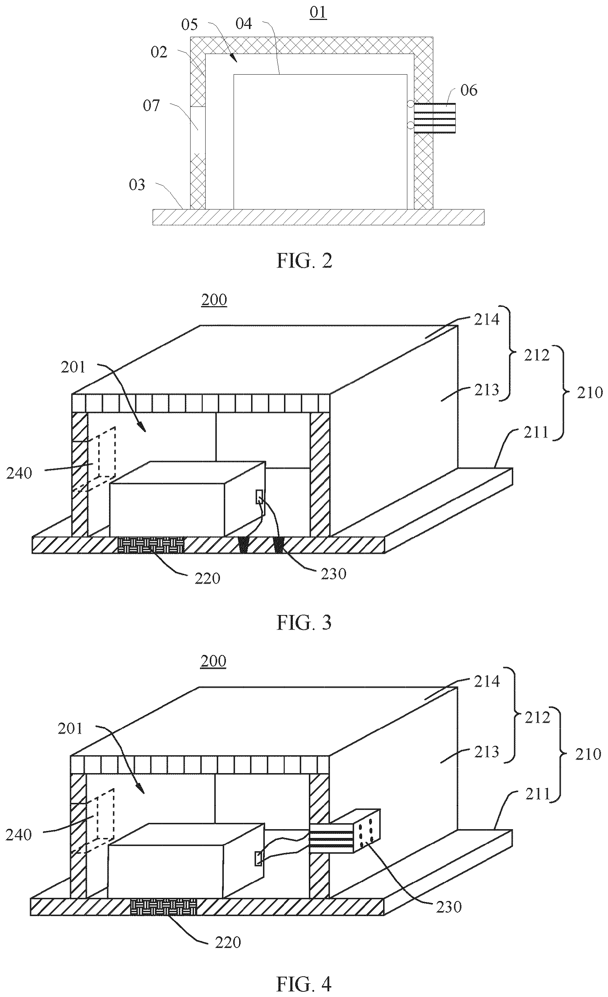

FIG. 2 is a diagram of a structure of a housing packaging structure 01 in a related technology. In FIG. 2, the housing packaging structure 01 includes a housing 02, a bottom plate 03, a chip 04, and a high-temperature co-fired ceramic piece 05.

The housing 02 and the bottom plate 03 are connected in a sealed manner to form an accommodating cavity 06. The chip 04 is located in the accommodating cavity 06, the high-temperature co-fired ceramic piece 05 runs through the housing 02, and the high-temperature co-fired ceramic piece 05 is electrically connected to the chip 04. The housing 02 is provided with an optical window 07, and the optical window 07 runs through the housing 02. An optical signal of the chip 04 may pass through the optical window 07.

In FIG. 2, materials of the housing 02 and the bottom plate 03 are both metal. Material costs and processing costs are high. Therefore, an embodiment of this application provides a packaging assembly 12, to improve performance of the housing packaging structure 200, and improve reliability of the signal transmission device 20.

FIG. 3 is a diagram of a structure of the housing packaging structure 200 and the signal transmission device 20 according to an embodiment of this application. In FIG. 3, the housing packaging structure 200 includes a packaging housing 210, a thermally conductive portion 220, and an electrical connector 230.

The thermally conductive portion 220 is connected to the packaging housing 210, the thermally conductive portion 220 and the packaging housing 210 jointly form a sealed cavity 201, the sealed cavity 201 is configured to accommodate the signal transmission device 20, and a thermal conductivity coefficient of the thermally conductive portion 220 is greater than a thermal conductivity coefficient of the packaging housing 210.

The electrical connector 230 runs through the packaging housing 210, one end of the electrical connector 230 is configured to be electrically connected to the signal transmission device 20, and the other end is located outside the sealed cavity 201. The input end 101 is located at an end of the electrical connector 230 that is located outside the sealed cavity 201. For example, one end of the electrical connector 230 that is located in the sealed cavity 201 may be connected to a structure such as a power supply.

In this way, because the thermal conductivity coefficient of the thermally conductive portion 220 is greater than the thermal conductivity coefficient of the packaging housing 210, thermal conductive performance of the thermally conductive portion 220 is better than thermal conductive performance of the packaging housing 210. Heat in the sealed cavity 201 is preferentially transferred to the outside of the sealed cavity 201 by using the thermally conductive portion 220, to avoid impact on performance of the signal transmission device 20 due to poor thermal conductive performance of the housing packaging structure 200, and improve reliability of the signal transmission device 20. Because the electrical connector 230 is connected to the packaging housing 210, the heat in the sealed cavity 201 has small impact on the electrical connector 230, thereby ensuring good performance of connection between the signal transmission device 20 and the electrical connector 230. In addition, a material with poor thermal conductive performance may be selected for the packaging housing 210, so as to increase selectivity of a material for the packaging housing 210, and reduce material costs. For example, a material that is not easy to deform at a high temperature may be selected for the packaging housing 210, so as to avoid damage to performance of connection between the electrical connector 230 and the signal transmission device 20 caused by deformation of the housing packaging structure 200 in a high temperature environment. In addition, the packaging housing 210 that is not easy to deform can avoid reduction of air tightness of the sealed cavity 201 caused by deformation, and can improve reliability of the signal transmission device 20.

A material of the thermally conductive portion 220 is not limited in this embodiment of this application. For example, the material of the thermally conductive portion 220 includes a metal material. The metal material has good thermal conductive performance and good air tightness, which can improve a heat dissipation capability of the housing packaging structure 200.

For example, the material of the thermally conductive portion 220 includes at least one of copper, silicon, AlN, Al₂O₃, and copper-tungsten alloy. The foregoing material has good thermal conductive performance and a large thermal conductivity coefficient, which provides good protection for heat dissipation performance of the housing packaging structure 200.

A shape and a size of the thermally conductive portion 220 are not limited in this embodiment of this application, and may be set based on the thermal conductivity coefficient of the thermally conductive portion 220 and heat dissipated by the signal transmission device 20 in a working state.

The structure of the packaging housing 210 is not limited in this embodiment of this application. For example, the packaging housing 210 includes a substrate 211 and a cover 212, and the cover 212 is located on one side of the substrate 211 and is connected to the substrate 211. The electrical connector 230 is connected to the substrate 211.

A manner of connecting the thermally conductive portion 220 to the substrate 211 is not limited in this embodiment of this application. For example, the substrate 211 is provided with a thermally conductive hole, the thermally conductive hole runs through the substrate 211, and the thermally conductive portion 220 is located in the substrate 211 and is connected to the substrate 211.

A quantity of thermally conductive portions 220 is not limited in this embodiment of this application. For example, there may be one, two, or more thermally conductive portions 220.

Relative locations of the thermally conductive portion 220 and the substrate 211 are not limited in this embodiment of this application. For example, the substrate 211 is disposed around the thermally conductive portion 220 and is connected to the thermally conductive portion 220, or the thermally conductive portion 220 is connected to one end of the substrate 211. Alternatively, the thermally conductive portion 220 is disposed around the substrate 211 and is connected to the substrate 211.

A manner of connecting the thermally conductive portion 220 to the signal transmission device 20 is not limited in this embodiment of this application. For example, the thermally conductive portion 220 is in direct contact with the signal transmission device 20, so that a thermal conduction distance between the thermally conductive portion 220 and the signal transmission device 20 can be shortened, and a thermal conduction capability can be improved. For example, the thermally conductive portion 220 is bonded to the signal transmission device 20.

In FIG. 3, the thermally conductive portion 220 runs through the substrate 211, and the electrical connector 230 runs through the substrate 211. The thermally conductive portion 220, the substrate 211, and the cover 212 together form the sealed cavity 201. The thermal conductivity coefficient of the thermally conductive portion 220 is greater than a thermal conductivity coefficient of the substrate 211.

In this way, the signal transmission device 20 may be mechanically connected to the substrate 211, and the signal transmission device 20 is electrically connected to the electrical connector 230. Both heat of the signal transmission device 20 and heat of the substrate 211 may be transferred to the outside of the sealed cavity 201 by using the thermally conductive portion 220. In addition, the electrical connector 230 and the thermally conductive portion 220 are independently disposed. Therefore, even if the thermally conductive portion 220 deforms, impact of the deformation on the signal transmission device 20 is small. A material that is not easy to deform may be selected for the substrate 211, to reduce poor contact between the signal transmission device 20 and the electrical connector 230 caused by warping of the substrate 211, thereby improving reliability of the signal transmission device 20.

A location relationship between the thermally conductive portion 220 and the electrical connector 230 is not limited to the example shown in FIG. 3. For example, in some embodiments, the thermally conductive portion 220 runs through the substrate 211, or the electrical connector 230 runs through the cover 212. Alternatively, in some other embodiments of this application, the electrical connector 230 runs through a joint between the substrate 211 and the cover 212.

A manner of electrically connecting the thermally conductive portion 220 to the electrical connector 230 is not limited in this embodiment of this application. For example, the thermally conductive portion 220 may be electrically connected to the electrical connector 230 by using a bonding wire, or may be electrically connected by using a surface mounted technology.

A shape of the sealed cavity 201 is not limited in this embodiment of this application. The shape of the sealed cavity 201 may be set based on a shape of the signal transmission device 20. For example, the sealed cavity 201 is a square cavity.

A material of the substrate 211 is not limited in this embodiment of this application. For example, the material of the substrate 211 includes at least one of glass, AIN, Al₂O₃, SiC, AlSiC, and a Kovar (Kovar) alloy. The foregoing materials all adapt to a coefficient of thermal expansion of the signal transmission device 20, a coefficient of thermal expansion of the substrate 211 adapts to that of the signal transmission device 20, and a deformation amount of the substrate 211 is close to that of the signal transmission device 20. After a temperature of the packaging assembly 12 changes, the substrate 211 is in good contact with the signal transmission device 20, and mechanical reliability is good, thereby helping improve reliability of the housing packaging structure 200.

In an embodiment in which the material of the substrate 211 is glass, material costs of the substrate 211 are low. In addition, in an embodiment in which the material of the substrate 211 is glass, and the material of the thermally conductive portion 220 is at least one of copper, silicon, AlN, and copper-tungsten alloy, the coefficient of thermal expansion of the substrate 211 adapts to that of the thermally conductive portion 220, thereby helping improve reliability of the housing packaging structure 200.

Similarly, a shape of the cover 212 is not limited in this embodiment of this application. The shape of the cover 212 may be set based on the shape of the signal transmission device 20. For example, the cover 212 is a square cover.

In this embodiment of this application, the cover 212 includes a top plate 213 and an enclosure plate 214. The top plate 213 and the enclosure plate 214 are connected to each other. The top plate 213 and the substrate 211 are disposed opposite to each other, and the substrate 211 is connected to the enclosure plate 214.

In some embodiments of this application, after the housing packaging structure 200 is prepared, the substrate 211 and the enclosure plate 214 are in a connected state, the top plate 213 and the enclosure plate 214 are in an unconnected state, and the sealed cavity 201 is not formed. When the signal transmission device 20 is packaged or the packaging assembly 12 is prepared by using the housing packaging structure 200, the top plate 213 and the enclosure plate 214 are connected to form the sealed cavity 201.

In some other embodiments of this application, after the housing packaging structure 200 is prepared, the substrate 211 and the enclosure plate 214 are in an unconnected state, the top plate 213 and the enclosure plate 214 are in a connected state, and the sealed cavity 201 is not formed. When the signal transmission device 20 is packaged by using the housing packaging structure 200 or when the packaging assembly 12 is prepared, the substrate 211 and the enclosure plate 214 are connected to form the sealed cavity 201.

A manner of connecting the top plate 213 to the enclosure plate 214 is not limited in this embodiment of this application. For example, the top plate 213 and the enclosure plate 214 are welded or bonded. Alternatively, the top plate 213 and the enclosure plate 214 are integrally formed.

Similarly, a manner of connecting the enclosure plate 214 to the substrate 211 is not limited in this embodiment of this application. For example, the enclosure plate 214 and the substrate 211 are welded or bonded.

Materials of the top plate 213 and the enclosure plate 214 are not limited in this embodiment of this application. For example, the materials of the top plate 213 and the enclosure plate 214 are both glass. The top plate 213 and the enclosure plate 214 of the glass material may provide good air tightness for the sealed cavity 201. In addition, in an embodiment in which the material of the substrate 211 is at least one of glass, AlN, Al₂O₃, SiC, AlSiC, a Kovar (Kovar) alloy, and an Invar (Invar) alloy, a coefficient of thermal expansion of the enclosure plate 214 of the glass material adapts to that of the substrate 211, and a joint between the enclosure plate 214 and the substrate 211 is not easily cracked due to internal stress.

Alternatively, in some embodiments, materials of the top plate 213 and the enclosure plate 214 may be SiC, AlSiC, AlN, Al₂O₃, a Kovar (Kovar) alloy, an Invar (Invar) alloy, and the like.

A structure of the electrical connector 230 is not limited in this embodiment of this application. For example, the electrical connector 230 may be a high-temperature co-fired ceramic (high-temperature co-fired ceramic, HTCC) piece, or the electrical connector 230 may be a metal piece, or the electrical connector 230 may be a cured electrically conductive slurry.

In FIG. 3, the substrate 211 is provided with a through hole, and the electrical connector 230 is a conductive material filled in the through hole. For example, a method for preparing the electrical connector 230 may be: providing the through hole on the substrate 211 by using a laser or etching method, and filling the through hole with the conductive material through electroplating, chemical plating, or magnetron sputtering; or filling the through hole with an electrically conductive slurry, and then curing the electrically conductive slurry. In this way, preparation costs of the electrical connector 230 in FIG. 3 are low, and the electrical connector 230 is small in size and occupies small space. In addition, a distribution manner of the electrical connectors 230 on the substrate 211 may be set according to a requirement.

It may be understood that, in another embodiment, the electrical connector 230 shown in FIG. 3 may alternatively be disposed on the enclosure plate 214 or the top plate 213.

FIG. 4 is a diagram of another structure of the housing packaging structure 200 and the signal transmission device 20 according to an embodiment of this application. A difference between FIG. 4 and FIG. 3 lies in a structure of the electrical connector 230. For other descriptions, refer to the example shown in FIG. 3. In FIG. 4, the electrical connector 230 is a high-temperature co-fired ceramic piece, and the electrical connector 230 runs through the enclosure plate 214. The electrical connector 230 is connected to the signal transmission device 20 by using a bonding wire. The high-temperature co-fired ceramic piece has good mechanical performance, and the electrical connector 230 is not easy to deform, thereby ensuring good mechanical performance of the housing packaging structure 200.

The high-temperature co-fired ceramic piece is welded to the enclosure plate 214. In some embodiments, a melting point of a material of the enclosure plate 214 is close to that of the high-temperature co-fired ceramic piece, so as to avoid a gap or a bubble between the high-temperature co-fired ceramic piece and the enclosure plate 214, and improve air tightness of the housing packaging structure 200.

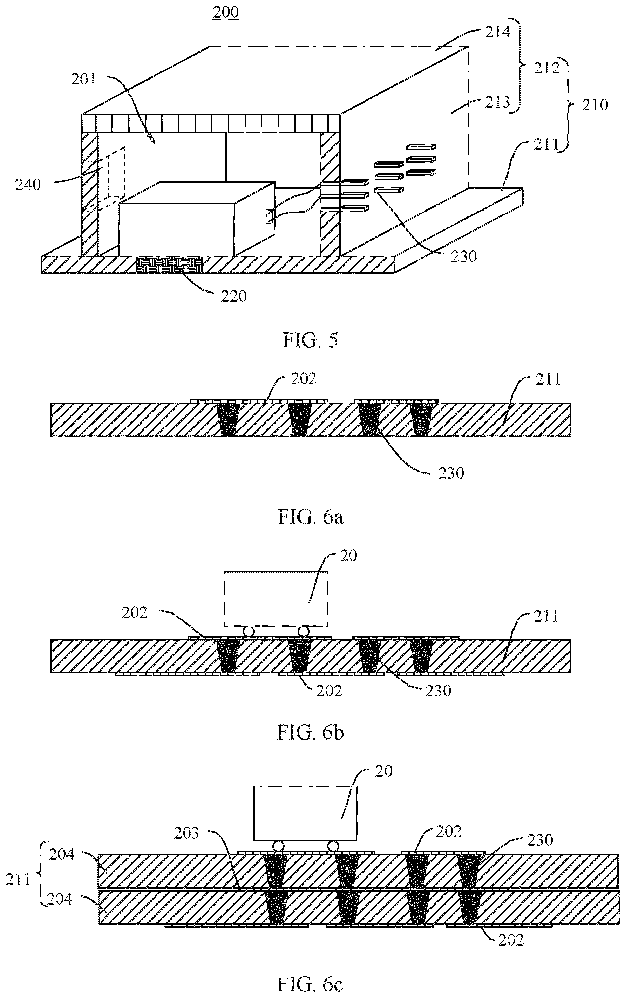

FIG. 5 is a diagram of still another structure of the housing packaging structure 200 and the signal transmission device 20 according to an embodiment of this application. A difference between FIG. 5 and FIG. 3 lies in a structure of the electrical connector 230. For other descriptions, refer to the example shown in FIG. 3. In FIG. 5, the electrical connector 230 includes a plurality of metal poles, and the plurality of metal poles are distributed in arrays. Each metal pole runs through the enclosure plate 214, and a metal pole with a large diameter may be selected, for example, a wall-inserted pin. The wall-inserted pin has good mechanical performance, and guarantees good mechanical performance of the housing packaging structure 200.

It may be understood that the electrical connector 230 in FIG. 4 and FIG. 5 may be disposed on the substrate 211 or the top plate 213.

In some embodiments, to fully use space of the housing packaging structure 200, the housing packaging structure 200 may further include a wiring layer. The wiring layer is electrically connected to the electrical connector 230. This can enrich wiring solutions of the housing packaging structure 200.

In this embodiment of this application, the wiring layer may be located on an inner surface of the packaging housing 210 or an outer surface of the packaging housing 210, or the wiring layer may be located between the inner surface and the outer surface of the packaging housing 210. Similarly, the wiring layer may be disposed on the substrate 211, the top plate 213, or the enclosure plate 214 based on a location of the electrical connector 230.

The wiring layer is not connected to the thermally conductive portion 220. In this way, deformation of the thermally conductive portion 220 has small impact on the wiring layer, and deformation of the thermally conductive portion 220 has small impact on an electrical connection between the wiring layer and the electrical connector 230, thereby improving electrical performance of the housing packaging structure 200.

A material of the wiring layer is not limited in this embodiment of this application. For example, the material of the wiring layer may be a material such as copper or gold.

FIG. 6a is a diagram of a structure of the substrate 211 and the electrical connector 230 according to an embodiment of this application. Refer to FIG. 6a. One surface of the substrate 211 is connected to a first wiring layer 202, and the first wiring layer 202 is connected to one end of the electrical connector 230.

The first wiring layer 202 may increase a length of wiring in the housing packaging structure 200, expand wiring space of the housing packaging structure 200, and increase wiring design solutions of the housing packaging structure 200.

A location relationship between the first wiring layer 202 and the sealed cavity 201 is not limited in this embodiment of this application. For example, the first wiring layer 202 is located in the sealed cavity 201, the first wiring layer 202 is electrically connected to one end of the electrical connector 230 that is located in the sealed cavity 201, and the signal transmission device 20 is electrically connected to the first wiring layer 202. Alternatively, the first wiring layer 202 is located outside the sealed cavity 201, and the first wiring layer 202 is electrically connected to one end of the electrical connector 230 that is located outside the sealed cavity 201. In FIG. 6a, one side of the substrate 211 that is closer to the first wiring layer 202 may be located in the sealed cavity 201, or may be located outside the sealed cavity 201.

FIG. 6b is a diagram of another structure of the substrate 211, the electrical connector 230, and the signal transmission device 20 according to an embodiment of this application. Refer to FIG. 6b. Two surfaces of the substrate 211 are both connected to first wiring layers 202. One end of the electrical connector 230 is electrically connected to one first wiring layers 202, and the other end of the electrical connector 230 is electrically connected to the other first wiring layer 202. The first wiring layer 202 located in the sealed cavity 201 is connected to the signal transmission device 20, and the first wiring layer 202 located outside the sealed cavity 201 is configured to be electrically connected to another structure such as a power supply.

In the example in FIG. 6b, a length of wiring in the housing packaging structure 200 is long, and wiring space of the housing packaging structure 200 is further increased. A part of circuit design may be disposed on the first wiring layer 202, to fully use space of the housing packaging structure 200.

FIG. 6c is a diagram of still another structure of the substrate 211, the electrical connector 230, and the signal transmission device 20 according to an embodiment of this application. Refer to FIG. 6c. The substrate 211 includes two support layers 204, and a second wiring layer 203 is disposed between the two support layers 204. The electrical connector 230 runs through each support layer 204, and the second wiring layer 203 is electrically connected to the first wiring layer 202 by using the electrical connector 230. In this way, a wiring path may be further extended, and wiring space of the housing packaging structure 200 may be expanded.

In FIG. 6c, materials of the two support layers 204 may be the same or may be different. For example, a material whose coefficient of thermal expansion is close to that of a material of the signal transmission device 20 is selected as a material of the support layer 204 closer to the sealed cavity 201. This can reduce internal stress between the signal transmission device 20 and the support layer 204 closer to the sealed cavity 201, to avoid a problem such as poor contact caused by the internal stress. A material with good thermal conductive performance is selected as a material of the support layer 204 away from the sealed cavity 201, to improve thermal conductive performance of the substrate 211.

In some embodiments, the support layer 204 may have more layers, for example, three, four, or more layers. A second wiring layer 203 is disposed between two support layers 204. The second wiring layer 203 is electrically connected to the electrical connector 230 that runs through the support layer 204. Similarly, structures of the support layers 204 may be the same or may be different.

It may be understood that, in an embodiment in which the substrate 211 includes a plurality of support layers 204, a second wiring layer 203 may not be disposed between two support layers 204. Similarly, structures of the support layers 204 may be the same or may be different.

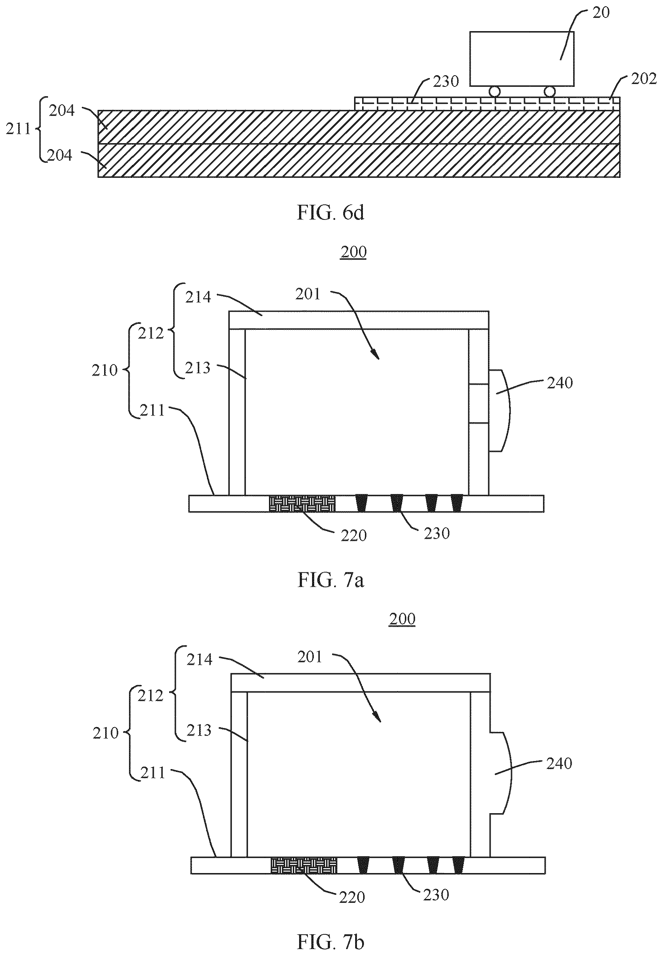

Alternatively, in some embodiments, the first wiring layer 202 and the electrical connector 230 are integrally formed. For example, FIG. 6d is a diagram of yet another structure of the substrate 211, the electrical connector 230, and the signal transmission device 20 according to an embodiment of this application. Refer to FIG. 6d. The substrate 211 includes two support layers 204, a surface of the support layer 204 is provided with a first wiring layer 202, and the first wiring layer 202 is also used as the electrical connector 230.

For example, an upper surface in FIG. 6d is a surface of the substrate 211 that faces the sealed cavity, and one end of the first wiring layer 202 is located in the sealed cavity and is configured to be electrically connected to the signal transmission device. The other end of the first wiring layer 202 is located outside the sealed cavity.

Similar to FIG. 6d, in an embodiment in which the substrate 211 includes one, three, four, or more support layers 204, the first wiring layer 202 and the electrical connector 230 are integrally formed. Details are not described herein.

As described above, the electrical connector 230 may be disposed at any location of the packaging housing 210. For example, the electrical connector 230 may be disposed on the top plate 213, or the electrical connector 230 may be disposed on the enclosure plate 214. It may be understood that, in an embodiment in which the electrical connector 230 is disposed on the top plate 213 or the enclosure plate 214, for a structural relationship between the top plate 213 and the electrical connector 230 or a structural relationship between the enclosure plate 214 and the electrical connector 230, refer to the structural relationship between the substrate 211 and the electrical connector 230 shown in FIG. 6a, FIG. 6b, FIG. 6c, or FIG. 6d. Details are not described herein.

Refer to FIG. 1b again. In an embodiment in which the signal transmission device 20 is a device such as a light source, an optoelectronic device, or a light emitting chip, the output end 102 is an optical interface. In this way, the housing packaging structure 200 needs to be provided with a transparent portion 240 for light to pass through. The transparent portion 240 is connected to the packaging housing 210. The following describes a structure of the transparent portion 240 by using an example.

Refer to FIG. 3 again. A location of the transparent portion 240 is not limited in this embodiment of this application. The transparent portion 240 may be disposed based on an installation location of the signal transmission device 20 in the sealed cavity 201. For example, the transparent portion 240 may be connected to the substrate 211, the top plate 213, or the enclosure plate 214. The following uses an example in which the transparent portion 240 is connected to the enclosure plate 214 for description.

A location relationship between the transparent portion 240 and the electrical connector 230 is not limited in this embodiment of this application. The setting may be performed based on relative locations of the electrical interface and the optical interface of the signal transmission device 20. For example, a projection of the optical interface of the signal transmission device 20 on the packaging housing 210 is located in an area of the transparent portion 240, so that an optical signal output by the optical interface of the signal transmission device 20 can be propagated to the transparent portion 240.

The transparent portion 240 is connected to the enclosure plate 214, and the electrical connector 230 is connected to the substrate 211. In this way, a light emitting direction of the transparent portion 240 is not parallel to an extension direction of the electrical connector 230, and the optical interface and the electrical interface of the signal transmission device 20 can be well avoided. For example, in FIG. 3, a bottom of the housing packaging structure 200 is connected to another structure such as a power supply, and a side of the housing packaging structure 200 may emit light.

A manner of connecting the transparent portion 240 to the enclosure plate 214 is not limited in this embodiment of this application. In FIG. 3, the transparent portion 240 and the enclosure plate 214 are integrally formed, and a material of the enclosure plate 214 is also glass. Material costs of the enclosure plate 214 are low, and material and preparation costs of the transparent portion 240 are also low. Alternatively, in some embodiments, the transparent portion 240 is connected to the enclosure plate 214 by using a connecting piece, and the connecting piece may be a bonding layer or a welding layer, or the transparent portion 240 and the enclosure plate 214 are integrally formed.

FIG. 7a is a diagram of a structure of the transparent portion 240 and the enclosure plate 214 according to an embodiment of this application. In FIG. 7a, the transparent portion 240 is bonded to the enclosure plate 214. For example, the enclosure plate 214 is provided with a transparent window, and the transparent window runs through the enclosure plate 214 to communicate with the sealed cavity 201. The transparent portion 240 is connected to the enclosure plate 214 and covers the transparent window. The transparent portion 240 and the enclosure plate 214 may be independently manufactured and then connected. Selection of a material of the transparent portion 240 is weakly associated with selection of a material of the enclosure plate 214. There are a large quantity of materials of the enclosure plate 214. The material of the enclosure plate 214 may be selected based on costs, performance of the enclosure plate 214, and the like.

FIG. 7b is a diagram of another structure of the transparent portion 240 and the enclosure plate 214 according to an embodiment of this application. In FIG. 7b, the transparent portion 240 and the enclosure plate 214 are integrally formed. For example, the transparent portion 240 and the enclosure plate 214 are formed by using a molding process. For example, in an embodiment in which a material of the enclosure plate 214 is a transparent material (for example, glass), the enclosure plate 214 may allow light to pass through, and a part or all of an area of the enclosure plate 214 may be used as the transparent portion 240. In this way, a preparation process of the transparent portion 240 and the enclosure plate 214 can be simplified, and a preparation process is reduced. In addition, a defect such as a bubble or a gap is not easily present at a joint between the transparent portion 240 and the enclosure plate 214, thereby helping improve air tightness of the sealed cavity 201.

A shape of the transparent portion 240 is not limited in this embodiment of this application. For example, the transparent portion 240 may be a planar mirror, or the transparent portion 240 may be a curved mirror. The light that passes through the transparent portion 240 may be shaped by using a shape design of the transparent portion 240.

In an embodiment in which the packaging assembly 12 has the transparent portion 240, the packaging assembly 12 may be connected to an optical element such as an optical fiber or an optical cable, so that an optical signal of the signal transmission device 20 is coupled from the transparent portion 240 to the optical element. Alternatively, because the light is reversible, an optical signal of the optical element is coupled from the transparent portion 240 to the signal transmission device 20.

In some embodiments, a shape of the transparent portion 240 may be designed, so that the transparent portion 240 is mechanically connected to another optical element while allowing light to pass through.

Further, in some embodiments of this application, to connect the housing packaging structure 200 to the optical element, the housing packaging structure 200 may further include a connection structure configured to adapt to the optical element, and the connection structure is configured to be connected to the optical element. A structure of the optical element is not limited in this embodiment of this application, and a structure of the connection structure is not limited in this embodiment of this application. The following uses some examples for description.

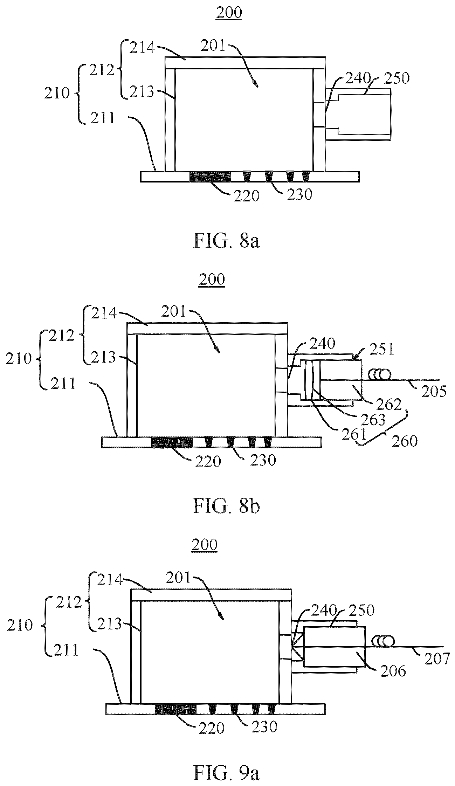

FIG. 8a is a diagram of a structure of the housing packaging structure 200 including an adapter 250 according to an embodiment of this application. Refer to FIG. 8a. The housing packaging structure 200 further includes the adapter 250. The adapter 250 is connected to the enclosure plate 214, and the transparent portion 240 is opposite to the adapter 250. A projection of the adapter 250 on a surface of the enclosure plate 214 is located in an area of the transparent portion 240, so that an optical signal in the sealed cavity 201 can be transferred to the adapter 250 by using the transparent portion 240.

The adapter 250 is configured to be connected to an optical element. In this way, the adapter 250 connected to the optical element may be prepared on the packaging housing 210. When the housing packaging structure 200 is connected to the optical element, assembly time of the adapter 250 may be reduced, and an assembly and adjustment process of the transparent portion 240 and the adapter 250 may be omitted, thereby reducing assembly and adjustment costs.

A material of the adapter 250 is not limited in this embodiment of this application. For example, the material of the adapter 250 may be glass or metal. In an embodiment in which the adapter 250 is glass, a coefficient of thermal expansion of the adapter 250 adapts to that of the transparent portion 240, a deformation amount of the adapter 250 is close to that of the transparent portion 240 at a high temperature, performance of connection between the adapter 250 and the transparent portion 240 is good, and a loss of an optical signal passing through the housing packaging structure 200 is small.

A structure of the adapter 250 is not limited in this embodiment of this application, and may be set based on a structure of the optical element. For example, the adapter 250 adapts to an optical fiber connector. The foregoing optical fiber connector may be, for example, an FC (ferrule connector) connector, an SC (square connector) optical fiber connector, a biconic connector (biconic connector) connector, an MU (miniature unit coupling) connector, or an LC (line connector) optical fiber connector. Alternatively, the foregoing optical fiber connector may be of another type.

A manner of connecting the adapter 250 to the enclosure plate 214 is not limited in this embodiment of this application. For example, the adapter 250 is connected to the enclosure plate 214 by using a connecting piece, and the connecting piece may be a bonding piece or a welding layer. Alternatively, in some embodiments, the adapter 250 and the enclosure plate 214 are integrally formed.

In some embodiments, according to an optical path design, a light leading-out assembly may be further configured in the housing packaging structure 200, and the light leading-out assembly is configured to be connected to an optical element.

FIG. 8b is a diagram of another structure of the housing packaging structure 200 including a light leading-out assembly 260 according to an embodiment of this application. In FIG. 8b, the housing packaging structure 200 further includes the light leading-out assembly 260, and the light leading-out assembly 260 includes a tube 261, an optical fiber 205, and a fastener 262. The fastener 262 is sleeved on the optical fiber 205, an accommodating channel 251 is disposed in the tube 261, the fastener 262 is located in the accommodating channel 251 and is connected to the tube 261, and a projection of the optical fiber 205 on a surface of the packaging housing 210 is located in an area of the transparent portion 240. In this way, the light leading-out assembly 260 may lead out an optical signal in the housing packaging structure 200 by using the optical fiber 205. This can reduce assembly time of the housing packaging structure 200 and an optical element.

Materials of the tube 261 and the fastener 262 are not limited in this embodiment of this application. For example, the materials of the tube 261 and the fastener 262 are both glass. In this way, the materials of the tube 261 and the fastener 262 are the same as a material of the transparent portion 240, so that a difference between coefficients of thermal expansion of the three can be reduced, and different connection strengths caused by different deformations at a same temperature can be avoided. In some embodiments, the materials of the tube 261 and the fastener 262 may be other materials such as ceramic.

For example, the optical fiber 205 may be connected to an optical cable or another optical fiber, so as to transfer an optical signal of the signal transmission device 20 in the housing packaging structure 200 to the optical cable or the another optical fiber.

A shape of the accommodating channel 251 is not limited in this embodiment of this application, and may be set based on a connection manner of the fastener 262 and the tube 261. For example, in an embodiment in which the fastener 262 and the tube 261 are in interference fit, an inner circumferential surface of the accommodating channel 251 is a circle. Alternatively, in an embodiment in which the fastener 262 and the tube 261 are clamped, a clamping part configured to be connected to the fastener 262 may be disposed on an inner wall of the accommodating channel 251.

In some embodiments, according to an optical path design, the housing packaging structure 200 may further include a lens assembly, and the lens assembly may shape light transmitted by the transparent portion 240, and the like.

In FIG. 8b, the housing packaging structure 200 further includes a lens assembly 263. The lens assembly 263 is located in the accommodating channel 251, and a projection of the lens assembly 263 on a surface of the packaging housing 210 is located in the transparent portion 240.

In the example in FIG. 8b, light may sequentially pass through the transparent portion 240 and the lens assembly 263. The lens assembly 263 may shape the light passing through the transparent portion 240, to adapt to different optical path designs.

The light passing through the transparent portion 240 enters the lens assembly 263, and the lens assembly 263 may shape the light passing through the transparent portion 240.

A structure of the lens assembly 263 is not limited in this embodiment of this application. For example, the lens assembly 263 includes at least one of spherical lens, aspherical lens, free-surface lens, optical focusing element, and Fresnel prism. For example, the lens assembly 263 may be a collimation lens or a lens array.

As described above, in some embodiments, the transparent portion 240 may alternatively be connected to the substrate 211 or the top plate 213. A manner of connecting the transparent portion 240 to the substrate 211 or a manner of connecting the transparent portion 240 to the top plate 213 is similar to a manner of connecting the transparent portion 240 to the enclosure plate 214. For details, refer to the foregoing descriptions in FIG. 7a, FIG. 7b, FIG. 8a, and FIG. 8b. Details are not described herein.

The transparent portion 240 may allow light emitted by the signal transmission device 20 to pass through, to provide a basis for optical communication between the signal transmission device 20 and the optical element. The following uses a connection between the optical fiber and the housing packaging structure 200 as an example for description.

FIG. 9a is a diagram of a structure of a connection between the housing packaging structure 200 shown in FIG. 8a and the optical element 207. Refer to FIG. 8a and FIG. 9a together. A ferrule 206 is sleeved on the optical element 207, and the ferrule 206 extends into the adapter 250 and is connected to the adapter 250.

Light passing through the transparent portion 240 enters the lens assembly 263, and light passing through the lens assembly 263 enters the optical element 207. In this way, optical signal communication between the signal transmission device 20 and the optical element 207 is implemented.

A structure of the optical element 207 is not limited in this embodiment of this application. For example, the optical element 207 may be an optical fiber, an optical cable, or an optical fiber array. There may be one, two, three, or more fiber cores in the optical element 207.

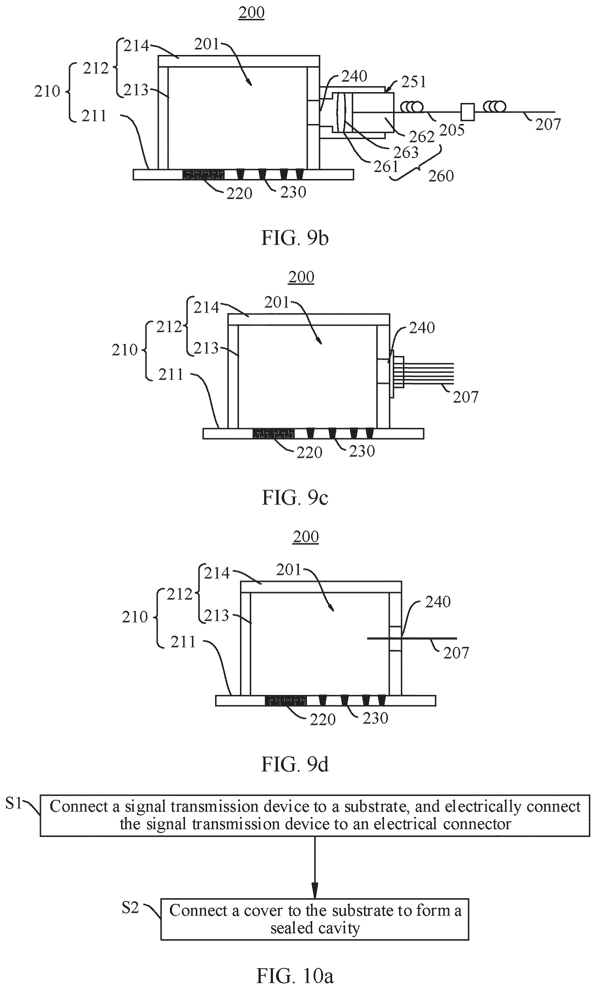

FIG. 9b is a diagram of a connection structure between the housing packaging structure 200 shown in FIG. 8b and the optical element 207. In FIG. 9b, the optical element 207 is connected to the optical fiber 205. An optical signal in the optical fiber 205 is propagated to the optical element 207. For example, the optical element 207 may be connected to the optical fiber 205 by using an optical fiber adapter.

It may be understood that the housing packaging structure 200 may be connected to the optical element 207 without using the adapter 250 or the light leading-out assembly 260.

FIG. 9c is a diagram of a connection structure between the housing packaging structure 200 and the optical element 207 according to an embodiment of this application. Refer to FIG. 9c. The optical element 207 is directly connected to the housing packaging structure 200, and the transparent portion 240 is opposite to the optical element 207. Light passing through the transparent portion 240 directly enters the optical element 207.

In FIG. 9c, the optical element 207 is an optical fiber array. The optical element 207 is located outside the sealed cavity 201, and a signal in the transparent portion 240 may be output by using the optical element 207.

FIG. 9d is a diagram of another connection structure between the housing packaging structure 200 and the optical element 207 according to an embodiment of this application. Refer to FIG. 9d. One end of the optical element 207 is located in the sealed cavity 201, and the other end is located outside the sealed cavity 201. In other words, the optical element 207 runs through the transparent portion 240. In this way, an optical signal in the sealed cavity 201 may be propagated to the outside of the sealed cavity 201 by using the optical element 207.

In the example in FIG. 9d, the optical element 207 is an optical fiber. Similarly, the optical element 207 may alternatively be a structure such as an optical cable.

In the example in FIG. 9d, a manner of connecting the optical element 207 and the transparent portion 240 is not limited. For example, the optical element 207 is bonded to the transparent portion 240 by using an adhesive layer, or the optical element 207 is welded to the transparent portion 240 by using a solder.

It may be understood that, in the examples in FIG. 9c and FIG. 9b, the optical element 207 may be manufactured and produced together with the transparent portion 240. Alternatively, the optical element 207 and the transparent portion 240 are separately produced and then assembled.

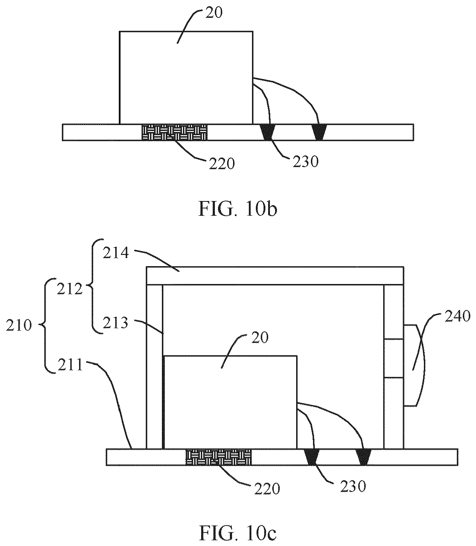

This embodiment of this application imposes no limitation on a process of packaging the signal transmission device 20 by using the housing packaging structure 200. The following describes the packaging process of the signal transmission device 20 by using an example with reference to FIG. 10a, FIG. 10b, and FIG. 10c.

For example, FIG. 10a is a flowchart of packaging the signal transmission device 20 by using the housing packaging structure 200 according to an embodiment of this application. Refer to FIG. 10a. A packaging process of the signal transmission device 20 includes the following steps.

S1: As shown in FIG. 10b, the signal transmission device 20 is connected to the substrate 211, and the signal transmission device 20 is electrically connected to the electrical connector 230.

FIG. 10b is a diagram of a structure obtained after S1 in FIG. 10a is performed. The signal transmission device 20 and the substrate 211 may be bonded or welded. The signal transmission device 20 may be electrically connected to the electrical connector 230 by using a bonding wire, or the signal transmission device 20 may be electrically connected to the electrical connector 230 by using a conductive adhesive.

S2: As shown in FIG. 10c, the cover 212 is connected to the substrate 211 to form the sealed cavity 201.

FIG. 10c is a diagram of a structure obtained after S2 in FIG. 10a is performed. The cover 212 and the substrate 211 may be welded or bonded.

In some embodiments, to prevent deformation of the thermally conductive portion 220 from affecting mechanical performance of the housing packaging structure 200, the thermally conductive portion 220 is not in direct contact with the cover 212 and the signal transmission device 20.

In an embodiment in which the enclosure plate 214 and the top plate 213 are integrally formed, the enclosure plate 214 and the substrate 211 may be directly connected.

In an embodiment in which the enclosure plate 214 and the top plate 213 are disposed separately, the enclosure plate 214 and the substrate 211 may be first connected, and then the enclosure plate 214 and the top plate 213 are connected to form the sealed cavity 201. Alternatively, the enclosure plate 214 and the top plate 213 may be first connected, and then the enclosure plate 214 and the substrate 211 are connected to form the sealed cavity 201.

A gas in the sealed cavity 201 is not limited in this embodiment of this application, and may be, for example, an inert gas such as nitrogen or argon. For example, S2 may be performed in an inert gas atmosphere, that is, the inert gas may be filled in the sealed cavity 201.

The housing packaging structure 200 provided in this embodiment of this application has good thermal conductive performance, and provides a good operating temperature for the signal transmission device 20, thereby prolonging reliability of the signal transmission device 20. In addition, the thermally conductive portion 220 provides a good thermally conductive effect. A material with good thermal conductive performance may not be selected for the packaging housing 210, for example, a material that supports the signal transmission device 20 well may be selected, or a material whose thermal conductivity coefficient is close to that of the signal transmission device 20 may be selected, to reduce thermal stress of the signal transmission device 20 and the packaging housing 210, thereby alleviating a problem of poor contact between the signal transmission device 20 and the electrical connector 230, and prolonging reliability of the signal transmission device 20.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A housing packaging structure, wherein the housing packaging structure is configured to package a signal transmission device, and the housing packaging structure comprises:
a packaging housing;
a thermally conductive portion, wherein the packaging housing is connected to the thermally conductive portion to form a sealed cavity, the sealed cavity is configured to accommodate the signal transmission device, and a thermal conductivity coefficient of the thermally conductive portion is greater than a thermal conductivity coefficient of the packaging housing;
an electrical connector, wherein the electrical connector runs through the packaging housing, one end of the electrical connector is configured to be electrically connected to the signal transmission device, and the other end is located outside the sealed cavity; and
a transparent portion, wherein the transparent portion and the packaging housing are integrally formed.

2. The housing packaging structure according to claim 1, wherein the transparent portion is of a curved-surface structure.

3. The housing packaging structure according to claim 1 or 2, wherein a material of the transparent portion comprises glass.

4. The housing packaging structure according to any one of claims 1 to 3, wherein the packaging housing comprises a substrate and a cover, the cover is located on one side of the substrate and is connected to the substrate, a material of the cover comprises glass, and the transparent portion and the cover are integrally formed.

5. The housing packaging structure according to claim 4, wherein the electrical connector runs through the substrate, the thermally conductive portion is connected to the substrate, and the thermal conductivity coefficient of the thermally conductive portion is greater than a thermal conductivity coefficient of the substrate.

6. The housing packaging structure according to any one of claims 1 to 5, wherein the housing packaging structure is further configured to be connected to an optical element, the housing packaging structure further comprises an adapter, the adapter is configured to be connected to the optical element, the adapter is connected to the packaging housing, and a projection of the adapter on a surface of the packaging housing is located in an area of the transparent portion.

7. The housing packaging structure according to claim 6, wherein a material of the adapter is glass.

8. The housing packaging structure according to claim 6 or 7, wherein the adapter and the packaging housing are integrally formed; or
the adapter is connected to the packaging housing by using a connecting piece.

9. The housing packaging structure according to any one of claims 1 to 5, wherein the housing packaging structure is further configured to be connected to an optical element, the housing packaging structure further comprises a light leading-out assembly, the light leading-out assembly comprises a tube, an optical fiber, and a fastener, the optical fiber is configured to be connected to the optical element, the fastener is sleeved on the optical fiber, an accommodating channel is disposed in the tube, the fastener is located in the accommodating channel and is connected to the tube, and a projection of the optical fiber on a surface of the packaging housing is located in an area of the transparent portion.

10. The housing packaging structure according to claim 9, wherein materials of the tube and the fastener are both glass.

11. The housing packaging structure according to claim 9 or 10, wherein the housing packaging structure further comprises a lens assembly, the lens assembly is located between the transparent portion and the fastener, and the lens assembly is connected to the tube.

12. The housing packaging structure according to any one of claims 1 to 5, wherein the transparent portion is connected to an optical fiber element, and the transparent portion is connected to an optical element by using the optical fiber element.

13. The housing packaging structure according to claim 12, wherein the optical fiber element exists in the sealed cavity.

14. The housing packaging structure according to claim 4 or 5, wherein the substrate is provided with a thermally conductive hole that runs through the substrate, and the thermally conductive portion is located in the thermally conductive hole.

15. The housing packaging structure according to claim 4 or 5, wherein the housing packaging structure further comprises a first wiring layer, the first wiring layer is connected to a surface of the substrate that faces or is away from the sealed cavity, and the first wiring layer is electrically connected to the electrical connector.

16. The housing packaging structure according to claim 15, wherein the first wiring layer and the electrical connector are integrally formed.

17. The housing packaging structure according to claim 15 or 16, wherein the housing packaging structure further comprises a second wiring layer, the substrate comprises a plurality of support layers disposed in a stacked manner, one second wiring layer is disposed between two adjacent support layers, the electrical connector runs through each support layer, and the second wiring layer is electrically connected to the electrical connector.

18. The housing packaging structure according to claim 4 or 5, wherein a material of the substrate comprises at least one of glass, AlN, Al₂O₃, SiC, AlSiC, and a Kovar alloy.

19. The housing packaging structure according to any one of claims 1 to 18, wherein a material of the thermally conductive portion comprises at least one of metal material and AlN.

20. The housing packaging structure according to claim 19, wherein the metal material comprises at least one of copper and copper-tungsten alloy.

21. The housing packaging structure according to any one of claims 1 to 20, wherein the electrical connector is formed by electroplating, chemical plating, sputtering, or electrically conductive slurry curing.

22. A packaging assembly, wherein the packaging assembly comprises:
a signal transmission device; and
the housing packaging structure according to any one of claims 1 to 21, wherein the signal transmission device is located in the sealed cavity, and the signal transmission device is electrically connected to the electrical connector.

23. The packaging assembly according to claim 22, wherein the signal transmission device comprises at least one of a light source, a receiver, a modulator, a chip, and a micro-electro-mechanical system device.

24. An electronic device, wherein the electronic device comprises a body and the packaging assembly according to claim 22 or 23, the packaging housing is connected to the body, and one end of the electrical connector that is located outside the sealed cavity is electrically connected to the body.

25. The electronic device according to claim 24, wherein the body comprises a power supply, a collimation lens, and an optical element, wherein the power supply is electrically connected to the signal transmission device, and light emitted by the signal transmission device passes through the collimation lens and is transferred to the optical element.
